# EUROPEAN PATENT SPECIFICATION

(11) **EP 0 326 327 B1**
(45) Date of publication and mention of the grant of the patent: **04.01.1995**
(21) Application number: 89300655.1
(22) Date of filing: 24.01.1989
(51) Int. Cl.: H04N 5/278

(54) **Apparatus for superimposing graphic title image signals onto a video signal**
Vorrichtung zur Überlagerung von graphischen Bildtitelsignalen auf einem Videosignal
Dispositif de superposition de signaux d'image de titres graphiques sur un signal vidéo

(30) Priority: 27.01.1988 JP 14554/88
(43) Date of publication of application: 02.08.1989
(73) Proprietor: SONY CORPORATION, Tokyo 141 (JP)
(72) Inventor: Yamazaki, Hiroshi c/o Patent Division, Shinagawa-ku Tokyo 141 (JP); Okazaki, Sakae c/o Patent Division, Shinagawa-ku Tokyo 141 (JP)
(74) Representative: Thomas, Christopher Hugo

(56) References cited:
- EP-A- 0 120 142
- EP-A- 0 131 454
- EP-A- 0 139 095
- PATENT ABSTRACTS OF JAPAN, vol. 10, no. 24 (E-377)[2081], 30th January 1986;& JP-A-60 182 879 (OLYMPUS) 18-09-1985
- PATENT ABSTRACTS OF JAPAN, vol. 9, no. 173 (E-329)[1896], 18th July 1985;& JP-A-60 46 686 (MATSUSHITA) 13-03-1985

## Description

This invention relates to an apparatus for superimposing graphic (for example, title) image signals onto a video signal, and for causing such superimposed images to scroll across the video picture derived from the video signal. Embodiments of the invention find application in so-called video titlers and telopers (or opaque projectors), and particularly in video cameras of the type having an image pick-up device and a video tape recorder (VTR) within the same housing.

Apparatus for superimposing graphic title images onto video signals have been developed as peripheral equipment for use with VTRs. Such graphic title images, referred to generally as graphics, are used in video dubbing to superimpose, or insert, graphic data onto a recorded video signal. As a result, a composite video signal containing graphic information is recorded.

Typical of such graphic inserting equipment are character generators which are capable of generating various types of alphanumeric patterns. The patterns formed by such character generators appear as title image signals, and are superimposed onto video signals that are reproduced from the VTR or that may be derived from an image pick-up device. However, such character generators are usually not suited for integration with presently available video cameras. A video camera is usually a hand-held device containing a VTR and an image pick-up section within the same housing. Character generators usually are too large, too heavy and too expensive to be integrated into such video cameras.

It has been proposed to provide video cameras with the capability of inserting graphics, such as graphic title image data, into the video signals generated by the image pick-up section. One suggestion is to use the image pick-up section to image graphics which, for example, may be drawn on a screen, poster, placard, or the like, thereby generating video signals corresponding to the imaged graphics, and then storing these graphic data in a suitable memory provided in the video camera. Thereafter, the stored graphic data may be read from the memory and superimposed onto the video signal then being generated by the image pick-up section (such as the video signal representing a scene being "photographed" by the image pick-up section). The video signal then being imaged, together with the superimposed graphic data may be recorded by the VTR section of the video camera.

The graphic insertion proposal of the type just described writes graphic data into the memory on a line-by-line basis, with each line generally being divided into several image units, analogous to pixels. The location of the graphic data that are read from the memory, relative to a picture image plane, is, of course, substantially identical to the location of those graphic data when they were written into the memory. Thus, if graphic material occupied the centre portion of the image plane when it was written into the memory, the graphics read from the memory and superimposed onto an input video signal likewise will occupy the centre portion of the image plane. Similarly, original graphics data disposed at the bottom or top of the image plane when written into the memory will occupy the bottom or top of that same image plane when read. Likewise, graphics data located to the left or right of the image plane when written will be superimposed to the left or right of the image plane when read. Thus, the particular position of the graphic data that are imaged by the pick-up section remains fixed when those graphic data are subsequently superimposed onto another video signal imaged by the pick-up section. The user of the video camera is provided with limited flexibility in adjusting the position of the graphic data after those data have been imaged and stored in the memory. Accordingly, a drawback of such graphic insertion apparatus is that the graphic data that are stored in the memory cannot subsequently be scrolled horizontally or vertically, relative to a video picture, or video image plane.

Patent Abstracts of Japan, Vol. 10, no. 24 (E-277)[2081] 30 January 1986 (and JP-A-60182879) discloses a video camera device comprising addressable storage means, address generating means, address control means and superimposing means interacting such as to superimpose a graphic image on a video image. That disclosure and the disclosure in European patent specification EP-A2-0 131 454 teach how characters can be scrolled.

European Patent Application Publication No. EP-A-0 139 095 discloses an apparatus for displaying graphic data obtained from stored graphic data, the graphic data being stored in storage means and the apparatus comprising address control means establishing an effective image range (corresponding to a "physical screen") corresponding to the effective picture area of a video picture (raster scan display) derived from the graphic data, and shift means for changing the addresses (by changing the starting read address of the graphic data memory and following ("linear") addresses in the address range defining the "physical screen") represented by the address signals generated by address generating means by a predetermined number of addresses (pel or character positions) for every display, output means being responsive to the generated changed addresses and the "physical screen" range of addresses to supply to image generating means the read out graphic image data from the graphic data storage means at intervals within the effective image range ("physical screen") and determined by the changed address signals, in order to generate a video picture representing a graphic image that scrolls (horizontally or/and vertically) across the display or effective image range.

According to the present invention there is provided an apparatus for superimposing graphic image signals onto a video signal, the apparatus comprising:
addressable storage means for storing graphic image data representing respective elements of respective horizontal lines of a graphic image;
a source of horizontal and vertical synchronizing signals synchronized with such signals of said video signal;
a source of clock pulses of a frequency which divides a horizontal line interval into multiple discrete zones;
horizontal and vertical address counting means for generating timed address signals to read out said image data from said addressable storage means;
means for supplying said clock pulses to said horizontal address counting means for counting thereby, whereby said count of said horizontal address counting means represents a horizontal address;
means for supplying said horizontal synchronizing signals to said vertical address counting means for counting thereby, whereby said count of said vertical address counting means represents a vertical address;
horizontal and vertical absolute position counters for counting said clock pulses and said horizontal synchronizing signals respectively;
means for resetting said horizontal and vertical absolute position counters in response to said horizontal and vertical synchronizing signals respectively;
horizontal and vertical counter control means coupled to said horizontal and vertical absolute position counters for setting said horizontal and vertical address counting means to preset counts when said horizontal and vertical absolute position counters reach predetermined counts;
horizontal and vertical image range defining means coupled to said horizontal and vertical address counting means and said horizontal and vertical absolute position counters for enabling reading of said graphic image data from said addressable storage means when counts of said horizontal and vertical absolute position counters are within an effective horizontal and vertical image range of addresses corresponding to the effective picture area (height and width) of a video picture derived from said video signal and counts of said horizontal and vertical address counting means are within a horizontal and vertical range corresponding to said graphic image data;
shift means for changing one or more of said preset counts by a predetermined number for every m repetition periods to scroll said graphic image across said picture area, wherein m is an integer and said repetition periods are either vertical field intervals or vertical frame intervals of said video signal;
image signal generating means for generating graphic image signals from said graphic image data read out from said storage means;
superimposing means for receiving said video signal and said graphic image signals to superimpose said graphic image signals onto said video signal; and
output means enabled by said horizontal and vertical counting control means to supply said image signal generating means read out graphic image data from said addressable storage means, whereby a video picture derived from said video signal output by said superimposing means represents a graphic image that scrolls said effective picture area.

In an embodiment of the invention, the apparatus is provided for superimposing graphic title image signals onto an input video signal. Graphic title image data are stored in an addressable store and are read out therefrom in response to address signals generated by an address generator. The data read from the store are used to generate graphic title image signals which are superimposed onto the input video signal. An address control is coupled to the address generator for establishing an effective image range of addresses to define an effective picture area (or image range) of a video picture derived from the graphic title image data. The sequence of the address signals relative to the effective range of addresses is selectively changed by a predetermined number of addresses for every m repetition periods (m is an integer and a repetition period is either a vertical field or a vertical frame) by an address shifter. The graphic title image data read from the store at intervals within the effective image range determined by the changed address signals are gated for superposition onto the input video signals and, as a result, the video picture derived from the graphic title image data represents a shifting graphic title image.

In a preferred embodiment, graphic title image data generated by an image pick-up device are written into an addressable memory under the control of horizontal and vertical address generators. Addresses representing discrete locations in successive horizontal lines are limited to those addresses which define an effective image plane, that is, an effective picture area. Subsequently, the same horizontal and vertical address generators are used to read out the graphic title image data from the stored locations within the memory. An output circuit, which functions as a gate, is enabled (or opened) at times corresponding to the effective image plane, thereby gating the read-out graphic title image data to circuitry which functions to superimpose the read-out data onto an input video signal.

Preferably, switches are selectively operated by a user to produce a horizontal and/or vertical scroll effect to the read out graphic title image data. This is achieved by changing the horizontal addresses generated by the horizontal address generator by a predetermined amount during each horizontal line interval to effect a horizontal scroll; and by changing the vertical addresses generated by the vertical address generator by another predetermined amount during every m field or frame intervals (m is an integer) to effect a vertical scroll of the graphic title image data. As an example, let it be assumed that of the 525 line intervals normally included in an NTSC video frame, approximately 480 lines define the effective picture area, or image plane. Vertical addresses 0, 1, 2, ... 479 are generated in synchronism with the usual horizontal synchronizing signal, such that address 0 is generated when, for example, the horizontal sync signal representing line 20 is present. To effect a vertical scroll, the vertical address may be changed such that, when line 20 of the conventional video frame is present, the vertical address generator may be preset to a count of two. This, of course, means that the graphic title image data that may have been stored at addresses 0 and 1 in the memory are not read or, alternatively, if read are not gated out for superposition. Then, m frames later, at line 20 of the normal video frame, the vertical address generator may be preset to a count of four. Now, the graphic title image data stored at vertical addresses 0, 1, 2 and 3 are not gated out for superposition. As this process continues, the graphic title image data superposed onto the video signal and eventually displayed appear to scroll vertically.

A similar operation is carried out with the horizontal address generator, thereby achieving a horizontal scrolling effect of the graphic title image data.

Thus, by changing the horizontal and vertical addresses within the effective image address range (that is, within the range of addresses which define the picture area), stored graphic title image data may be read out in time-shifted relationship to a field or frame interval, thereby shifting the position of the superposed graphic title image data on the video signal which, in turn, shifts the position at which the graphic title image data are displayed on the video picture. By shifting the addresses periodically, such as by a predetermined amount every m fields or frames, the displayed graphic title image information appears to scroll horizontally or vertically across the video picture.

As an advantageous feature, the graphic title image data are modulated with colour signal (R, G, B) to produce, for example, red, green or blue graphic title image data; and the colour graphic data are converted to luminance and colour difference signals for superposition onto the input video signal (which, preferably, is itself a composite colour video signal).

The invention will now be described by way of example with reference to the accompanying drawings, throughout which like parts are referred to by like references, and in which:
Figure 1 is a perspective view of a video camera incorporating an embodiment of the present invention;
Figure 2 is a block diagram of components of the video camera;
Figure 3 is a block diagram of an embodiment of the apparatus in accordance with the present invention;
Figure 4 is a diagrammatic representation of a graphic title image to be superimposed on an input video signal;
Figure 5 is a diagrammatic representation of a read/write operation;
Figure 6 is a diagrammatic representation of a horizontal scroll operation;
Figure 7 is a diagrammatic representation of a vertical scroll operation;
Figure 8 is a diagrammatic representation of how vertical addresses are controlled to achieve a vertical scroll; and
Figure 9 is a diagrammatic representation providing further explanation of the manner in which a vertical scroll is achieved.

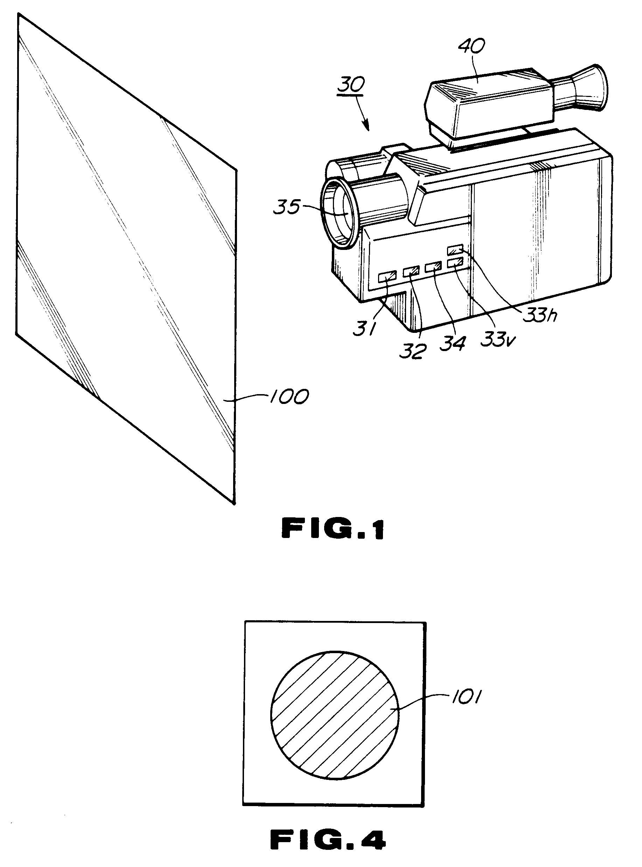

The present invention will be described as applied to a video camera having an image pick-up section and a VTR section, whereby an image that is picked up by the pick-up section is recorded as a video signal in the VTR section. The embodiment of the present invention is used in the video camera to superimpose graphics, such as graphic title image signals, onto the video signals picked up by the pick-up section and recorded by the VTR section. Figure 1 is a perspective view of a video camera 30 which includes a VTR section for recording video signals in the 8mm format.

As shown, the video camera 30 includes an imaging lens 35 and a photosensitive target, described in greater detail below, on which a scene imaged by the lens 35 is projected. The photosensitive device, described herein as a charge coupled device (CCD) is a standard image sensor used in video cameras to generate video signals. The video signals derived from the CCD and corresponding to the scene which is imaged by the lens 35 is displayed as a television picture in an electronic viewfinder 40.

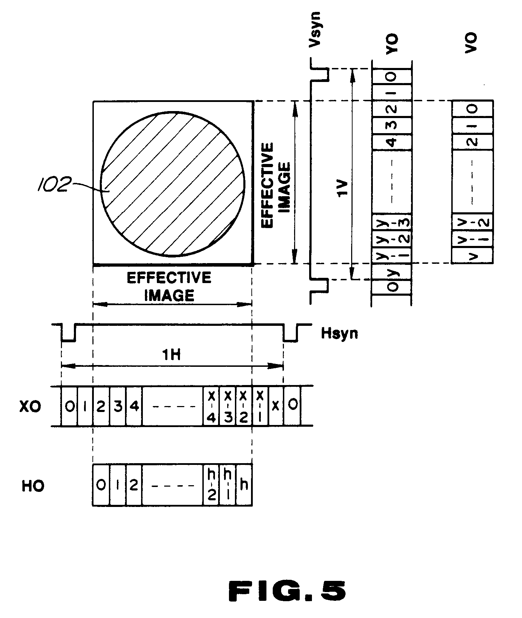

The video camera 30 also includes a series of switches 31 to 34 that are manually operable, and used for superimposing graphic title image signals onto the video signal generated by the CCD as a scene is imaged. Briefly, the switch 31, when actuated, stores graphic title image data in a memory included within the video camera 30. Typically, such graphic title image data are produced by using the video camera 30 to image graphic information provided on a poster, placard or the like. Figure 1 illustrates a placard 100 having graphic information 101 thereon which is picked up by the video camera 30. A schematic representation of the graphic information 101 is depicted in Figure 4. As will be described, digital representations of the video signals generated by imaging the placard 100 are written into the aforementioned memory when the switch 31 is actuated. The switch 32, when actuated, reads out the graphic title image data stored in the aforementioned memory and supplies those data to circuitry for conversion into video signals compatible with the video signals produced by the CCD when the video camera 30 is used to image a scene. These graphic video signals are superimposed onto the video signals which then are being picked up by the video camera 30.

Switches 33h and 33v, when actuated, effect horizontal and vertical scrolling, respectively, of the graphic video signals relative to the input video signal then being picked up by the video camera 30. As an example, when the switch 33h is actuated, the graphic title image signals scroll horizontally such that a video picture that may be derived from the graphic title image signals appears to move horizontally across the picture area. Likewise, the actuation of the switch 33v effects a vertical scrolling of the graphic title image signals relative to the video signals picked up by the video camera 30. As a result, a video picture derived from the graphic title image signals appears to scroll in the vertical direction. The manner in which this horizontal and vertical scrolling is achieved is described below.

Finally, the switch 34, when actuated, selects a particular colour representation for the graphic title image. For example, the switch 34 may select red, green or blue (R, G, B) colour signals to modulate the graphic title image data read from the memory, thereby presenting the graphic data as red, green or blue image data. As one example, successive actuations of the switch 34 serve to cycle the selected R, G B signal for modulating the graphic title image data. Still further, the switch 34 may be actuated to select composite R, G, B signals to modulate the graphic title image data, thereby resulting in a white graphic display. It is contemplated that combinations of RGB signals may be selected. Preferably, colour modulation is carried out only when the graphic title image data are read from the memory and supplied to the superposition circuitry, to be described.

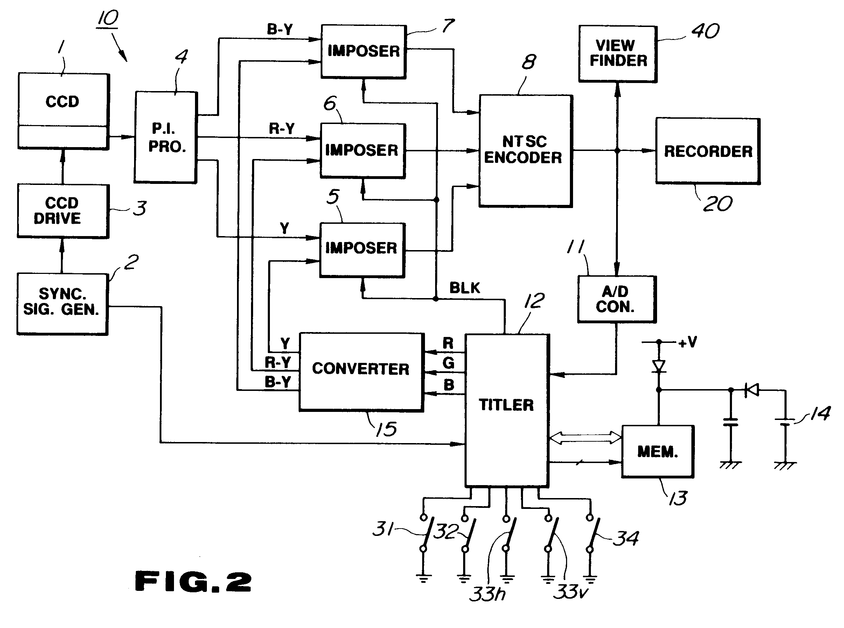

Turning now to Figure 2, there is illustrated a block diagram of some of the main components included in the video camera 30, including those components used to produce and superpose graphic title image signals onto a input video signal. Here, an image pick-up section 10 comprises a CCD 1, a synchronizing signal generator 2, a CCD drive circuit 3 and an image processing circuit 4. Figure 2 also illustrated a VTR 20 and the electronic viewfinder 40. As mentioned above, the CCD 1 is a photosensitive image pick-up device which, typically, is driven (or scanned) by the CCD drive circuit 3 under the control of horizontal and vertical synchronizing signals generated by the synchronizing signal generator 2. As a result, signals are derived from the CCD 1 representative of an optical image projected thereon. These image signals are processed by the image processing circuit 4 to produce luminance and colour difference video signals. The luminance signal Y and the colour difference signals (R-Y) and (B-Y) are supplied to an NTSC encoder 8 by way of superimposing circuits 5, 6 and 7, respectively, for the purpose of generating an NTSC encoded composite video signal. The NTSC-encoded video signal is supplied to the VTR 20, whereat it is recorded, and to the viewfinder 40, whereat a video picture corresponding to the NTSC-encoded video signal is displayed. The elements 1 to 4, the encoder 8, the VTR 20 and the viewfinder 40 are of known form.

The superimposing circuits 5, 6 and 7 superimpose onto the video signals supplied thereto by the image processing circuit 4, graphic title image signals derived from what is referred to herein as titler apparatus 12. The titler apparatus 12 includes a blanking signal output BLK together with R, G, B signal outputs, the latter being coupled to a converting circuit 15 which converts R, G, B signals to luminance and colour difference signals compatible with the luminance and colour difference signals produced by the image processing circuit 4. As shown, the luminance signals Y from the image processing circuit 4 and from the converting circuit 15 are coupled to the superimposing circuit 5. The red colour difference signals (R-Y) are supplied to the superimposing circuit 6 by the image processing circuit 4 and by the converting circuit 15. Finally, the blue colour difference signals (B-Y) are coupled by the image processing circuit 4 and the converting circuit 15 to the superimposing circuit 7. The superimposing circuits 5 to 7 may be thought of as switching circuits which normally pass the video signal components supplied thereto from the image processing circuit 4. However, in the presence of a blanking signal BLK from the titler apparatus 12, the superimposing circuits 5 to 7 pass the video signal components then being supplied by the converting circuit 15. Hence, portions of the video signal derived from the CCD 1 are replaced by graphic title image signals then being provided by the titler apparatus 12.

The titler apparatus 12 is coupled to the switches 31 to 34, which are explained in further detail below, for the purpose of controlling write and read operations, horizontal and vertical scroll operations, and colour selection of the graphic title image data. In addition, the titler apparatus 12 is coupled to an analogue-to-digital (A/D) converter 11 which, in turn, is coupled to the output of the NTSC encoder 8. The A/D converter 11 quantizes the video signal produced by the NTSC encoder 8, and particularly the luminance component therein, when the video camera 30 is used to image graphic information provided on the placard 100. In one embodiment, when the level of the luminance signal Y exceeds a predetermined threshold level, the A/D converter 11 supplies a binary "0" to the titler apparatus 12. When the level of the luminance signal Y is less than this threshold, the A/D converter 11 supplies a binary "1" to the titler apparatus. If graphic information 101 (Figure 4) is provided on a white background, a "1" produced the A/D converter 11 represents the presence of such graphic material.

Although the A/D converter 11 is described herein as a one-bit converter, it will be appreciated that it may be formed as a multi-bit converter.

The titler apparatus 12 also is coupled to a memory 13 which, in the preferred embodiment, is formed as a static random access memory (RAM). Graphic title image data produced by the titler apparatus 12 in response to the A/D converter 11 thus may be stored in the memory 13 for prolonged periods of time. To prevent destruction of such data in the event that the main power supply of the video camera 30 is interrupted, a back-up power supply having a lithium cell 14, or other long-term, low power drain battery, is coupled to the memory 13. Although not shown herein, the voltage produced by the lithium cell 14 is monitored by a voltage reduction detection circuit to provide a suitable alarm when the power level of the lithium cell 14 is reduced to some predetermined limit, and before the graphic title image data stored in the memory 13 are lost.

Briefly, in operation, the placard 100 having the graphic information 101 thereon is imaged by the video camera 30. An image of this graphic material, preferably written on a white background, is projected onto the CCD 1; and luminance and colour difference signals representing that image are produced by the image processing circuit 4. The luminance and colour difference signal are encoded as an NTSC video signal by the NTSC encoder 8; and the A/D converter 11 converts this analogue video signal to a succession of "1" and "0" bits in a line-by-line manner.

If the switch 31 is actuated, each line of digital information produced by the A/D converter 11 is stored at corresponding locations in the memory 13. In one embodiment, if the A/D converter 11 generates k bits over an entire line interval, for example, if a line interval is divided into k discrete image areas analogous to k pixels, the memory 13 may be provided with a number of rows, each row representing a line interval, with each row containing k storage locations. Alternatively, the memory 13 may be provided with a number of rows equal to the number of line intervals included in a video picture, with each storage location in a row being formed as an 8-bit store. In any event, the graphic title image data produced by the A/D converter 11 is stored in the memory 13 on a row-by-row basis, with each row corresponding to a horizontal line interval.

Once graphic title image data has been stored in the memory 13, the user of the video camera 30 now may operate it to image any desired scene. The imaged scene is projected on the CCD 1; and the image processing circuit 4 converts the projected image to luminance and colour difference signals. These signals are encoded by the NTSC encoder 8 and displayed in the viewfinder 40. If the user wishes, such video signals also may be recorded by the VTR 20.

If the user now wishes to superimpose the graphic title image information stored in the memory 13 onto the video signals which are being produced by the image processing circuit 4, the switch 32 is actuated to read out from the memory 13 the stored graphic title image data. These graphic title image data are read out in synchronism with the usual horizontal and vertical synchronizing signals and, thus, are synchronized with the video signals being produced by the image processing circuit 4. Depending upon the particular colour selection made by actuating the switch 34, the read out graphic title image data are modulated to produce an RGB signal, and the converting circuit 15 converts the RGB signal to luminance and colour difference signals corresponding thereto. These luminance and colour difference video signals representing the graphic title image are supplied to the superimposing circuits 5, 6 and 7 which replace portions of the input video signals supplied by the image processing circuit 4 with portions of the graphic title image signals that occupy the same position in the overall video picture. Thus, graphic title image signals are superimposed onto the input video signal, and the superimposed signals are displayed in the viewfinder 40. Such graphic information superimposed onto the scene picked up by the video camera 30 may be recorded in the VTR 20.

Additionally, if the switch 33h or the switch 33v is actuated, the superimposed graphic title image signals are scrolled horizontally or vertically, respectively, relative to the video signal upon which they are superimposed. Such horizontal and vertical movement appears in the video picture displayed by the viewfinder 40 and recorded by the VTR 20.

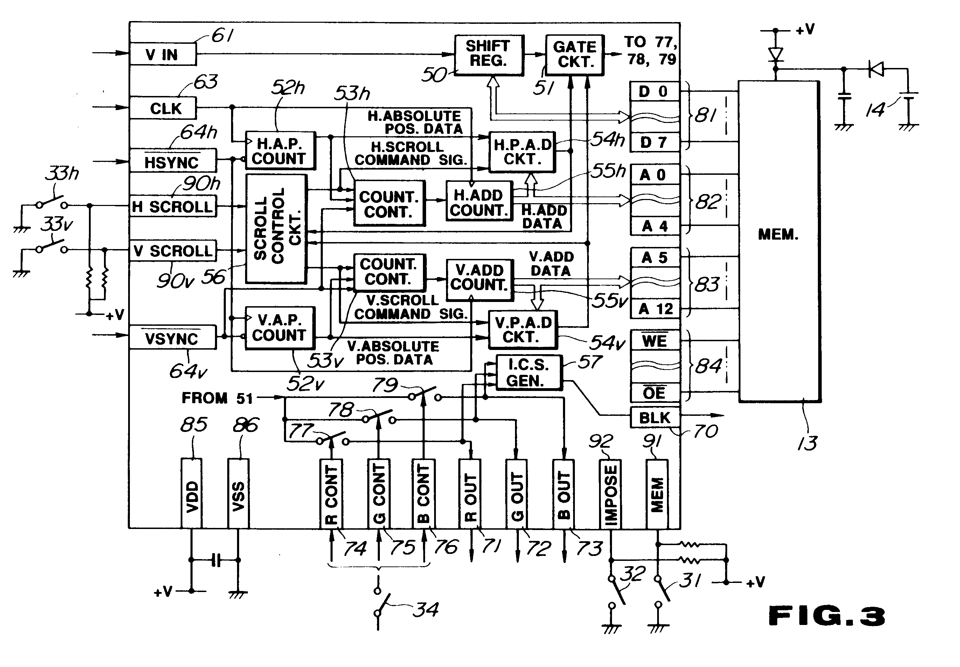

An embodiment of the titler apparatus 12 will now be described with reference to Figure 3. The titler apparatus 12 includes horizontal and vertical absolute position counters 52h and 52v, horizontal and vertical counter control circuits 53h and 53v, horizontal and vertical address counters 55h and 55v, horizontal and vertical image range defining circuits 54h and 54v, a scroll control circuit 56, a shift register 50 and a gate circuit 51. The shift register 50 is coupled to a video input terminal 61 and receives the quantized video signal produced by the A/D converter 11 (Figure 2). The shift register 50 converts the serial bits received from the A/D converter 11 to parallel form; and a parallel output of the shift register 50 is coupled to a data output port 81 connected to the memory 13. The shift register 50 also includes a serial output coupled to the gate circuit 51, the latter having enable inputs coupled to the horizontal and vertical image range defining circuits 54h and 54v. The gate circuit 51, upon receiving enable signals from both the image range defining circuits 54h and 54v, to pass serial bits supplied from the shift register 50 to output terminals 71, 72 and 73, to be described, and to a superimpose control signal generator 57 by way of selectively operated switches 77, 78 and 79.

The horizontal absolute position counter 52h is formed as a resettable counter having a clock input coupled to a clock terminal 63, and a reset input coupled to a horizontal synchronizing signal input terminal 64h. A suitable source of clock pulses (not shown) is coupled to the clock terminal 63 to supply clock pulses of a frequency which divides a horizontal line interval into multiple discrete zones, analogous to multiple pixels. The horizontal synchronizing signal input terminal 64h is coupled to the synchronizing signal generator 2 (Figure 2) to receive the horizontal synchronizing signals generated thereby. Thus, the horizontal absolute position counter 52h is reset at the beginning of each horizontal line interval and is then incremented by the clock pulses supplied thereto throughout that line interval. Hence, the count of the horizontal absolute position counter 52h represents a position along the horizontal line interval, and the output is coupled to the horizontal counter control circuit 53h, and also to the horizontal image range defining circuit 54h, as will be described.

Similarly, the vertical absolute position counter 52v includes a clock input coupled to the horizontal synchronizing signal input terminal 64h, and a reset input coupled to a vertical synchronizing signal input terminal 64v. The vertical absolute position counter 52v is reset in response to each vertical synchronizing signal supplied to the vertical synchronizing input terminal 64v which is coupled to the synchronizing signal generator 2 (Figure 2) to receive the vertical synchronizing signals generated thereby. The vertical absolute position counter 52v counts horizontal synchronizing signals; and it is seen that the count thereof represents a vertical position (or line number) in a video field interval. The count produced by the vertical absolute position counter 52v is coupled to the vertical counter control circuit 53v and to the vertical image range defining circuit 54v, as will be explained below.

The horizontal address counter 55h produces a count defining the effective horizontal image range of a video picture. It is appreciated that the effective horizontal image range is less than the interval between adjacent horizontal synchronizing signals. Whereas the horizontal absolute position counter 52h provides a count representing a position at any point between horizontal synchronizing signals, the horizontal address counter 55h provides a count representing a point within the left-right borders of the picture area. The horizontal address counter 55h includes a clock terminal coupled to the clock terminal 63 and a control input coupled to the horizontal counter control circuit 53h. The count produced by the horizontal address counter 55h functions as an address, and is coupled to a horizontal address port 82 for adding horizontal storage locations in the memory 13. This address count is also supplied to the horizontal image range defining circuit 54h, and is used to produce the horizontal enabling signal supplied to the gate circuit 51.

The vertical address counter 55v is similar to the horizontal address counter 55h in that it counts horizontal synchronizing signals supplied to the horizontal synchronizing signal input terminal 64h to provide a count within the effective vertical image range. That is, the count of the vertical address counter 55v is within the top and bottom borders of a video picture area. A control input of the vertical address counter 55v is coupled to the vertical counter control circuit 53v. The count produced by the vertical address counter 55v is coupled to a vertical address port 83 and is used to address vertical storage locations of the memory 13. This vertical address count is also supplied to the vertical image range defining circuit 54v, and is used to produce the vertical enabling signal supplied to the gate circuit 51.

The horizontal counter control circuit 53h presets the horizontal address counter 55h to a predetermined count when the count attained by the horizontal absolute position counter 52h reaches a previously determined amount. The horizontal counter control circuit 53h thus includes an input coupled to the output of the horizontal absolute position counter 52h. In addition, the horizontal counter control circuit 53h counts the vertical synchronizing signal to detect a count m, as will be described. Accordingly, a suitable input of the horizontal counter control circuit 53h is coupled to the vertical synchronizing signal input terminal 64v. Finally, the horizontal counter control circuit 53h includes a control input coupled to the scroll control circuit 56 for modifying the particular horizontal absolute position count which is detected by the horizontal counter control circuit 53h for presetting the horizontal address counter 55h, or for changing the preset count. As will be explained below, if the presetting of the horizontal address counter 55h changes relative to the horizontal absolute position count, or if the count to which the horizontal address counter 55h is preset is changed, the period during which the horizontal address counter 55h lies within the effective horizontal image range also varies, thereby varying the duration that the gate circuit 51 remains open. This, in turn, provides a horizontal scrolling effect to the graphic title image data read from the memory 13 and passed by the gate circuit 51.

The vertical counter control circuit 53v is similar to the horizontal counter control circuit 53h, and presets the vertical address counter 55v when the position count reached by the vertical absolute position counter 52v reaches a previously determined count. Accordingly, a control output of the vertical counter control circuit 53v is coupled to a preset input of the vertical address counter 55v. The vertical counter control circuit 53v counts vertical synchronizing signals and, therefore, an input is coupled to the vertical synchronizing signal input terminal 64v. Finally, a control input of the vertical counter control circuit 53v is coupled to the scroll control circuit 56 for receiving a scroll control signal therefrom. The vertical counter control circuit 53v responds to this scroll control signal to vary the vertical absolute position count that is detected for presetting the vertical address counter 55v or, alternatively, to vary the count to which the vertical address counter 55v is preset. As a result, the period during which the vertical address count remains within an address range defining the vertical image dimension changes; and this produces a vertical scrolling effect to the graphic title image data read from the memory 13 and passed by the gate circuit 51.

The scroll control circuit 56 is coupled to a horizontal scroll input terminal 90h which is supplied with a reference signal, such as earth potential, when the switch 33h is closed. In response to the closure of the switch 33h, the scroll control circuit 56 supplies a horizontal scroll control signal to the horizontal counter control circuit 53h. As mentioned about, this initiates and enables a horizontal scroll operation.

The scroll control circuit 56 is also coupled to a vertical scroll input terminal 90v which is supplied with a reference signal when the switch 33v is closed. The scroll control circuit 56 responds to this signal to supply a vertical scroll control signal to the vertical counter control circuit 53v, thereby initiating and enabling a vertical scroll operation. The scroll control circuit 56 is also coupled to the horizontal and vertical image range defining circuits 54h and 54v to control the gate enabling signals produced thereby. It will be appreciated that these enabling signals define the horizontal and vertical range within the effective image plane, or picture area, over which graphic title image data are read from the memory 13 and gated by the gate circuit 51.

The switch 34 is arranged, when closed, to provide a control signal to a red control input terminal 74, a green control input terminal 75 or a blue control input terminal 76. For example, in response to a first actuation of the switch 34, a control signal is supplied to the terminal 74. Upon the next actuation of the switch 34, the control signal is shifted from the terminal 74 to the terminal 75. Thus, the control signal cycles from one of the red, green and blue control input terminals to the next as the switch 34 is actuated.

The red control input terminal 74 is coupled to the switch 77 and, in similar manner, the green control input terminal 75 is coupled to the switch 78 and the blue control input terminal 76 is coupled to the switch 79. One of the switches 77, 78 and 79 is closed, depending upon which of the red, green and blue control input terminals is provided with a control signal. It is seen that the switches 77, 78 and 79 are connected in common to the output of the gate circuit 51, and each is coupled to a respective one of the red output terminal 71, the green output terminal 72 and the blue output terminal 73. Each is also coupled to the superimpose control signal generator 57 which, as an example, functions as an OR circuit to produce a blanking signal BLK coupled to an output terminal 70. The red, green and blue output terminals 71, 72 and 73 are coupled to colour signal modulators (not shown) for modulating the serial bits gated from the shift register 50 with R, G and B colour signals. Thus, the combination of the switches 77 and 79 and the output terminals 71 to 73, together with the colour signal modulator circuits connected to the output terminals 71 to 73, function to convert the bits gated from the shift register 50 to R, G, B colour signals. As discussed above with respect to Figure 2, these R, G, B colour signals are supplied to the converting circuit 15 for conversion into luminance and colour difference video signals. Thus, the graphic title image data gated from the shift register 50 is converted to luminance colour difference video signals, compatible with the colour video signals produced by the image processing circuit 4 (Figure 2).

The titler apparatus 12 also includes a write input terminal 91 and a read input terminal 92. The write switch 31 is coupled to the write input terminal 91 and the read switch 32 is coupled to the read input terminal 92. In response to the actuation of the write switch 31, a write enable circuit (not shown) coupled to the write input terminal 91 supplies write enable signals to a port 84 which, in turn, is coupled to the usual read/write control of the memory 13. Similarly, when the read switch 32 is closed, a read enable circuit (not shown) coupled to the read input terminal 92 supplies read enable signals to the port 84, thereby conditioning the memory 13 for a read-out operation.

The titler apparatus 12 also includes a power supply terminal 85 for receiving an operating potential, such as a positive potential, and an earth terminal 86 for receiving earth potential or an alternative reference voltage level.

The manner in which the titler apparatus 12 operates will now be described. Initially, a graphic title image data write operation is carried out to store in the memory 13 data representing graphic information, such as shown in Figure 4. Let it be assumed that the write switch 31 is closed, resulting in a write enable signal being supplied to the memory 13. Graphic image information picked up by the CCD 1 (Figure 2) results in an NTSC-encoded video signal having a luminance component being supplied to the A/D converter 11. The serial bits produced by the A/D converter 11 are shifted into the shift register 50. Although not shown, it is appreciated that the shift register 50 is shifted at a rate determined by (or synchronized with) the clock signals supplied to the clock terminal 63. Furthermore, these clock signals are synchronized with the horizontal drive (or scanning) operation by which the CCD 1 is scanned by the CCD drive circuit 3.

As a line of imaging elements of the CCD 1 is scanned, the horizontal absolute position counter 52h counts clock pulses to produce a count represented as count 0 in Figure 5. It is appreciated that this count represents the absolute position between adjacent horizontal synchronizing signals. Thus, the horizontal absolute position counter 52h counts from a count of 0 to a maximum count x and is reset to a count of 0 in response to the next-occurring horizontal synchronizing signal.

During a write operation, a scroll control signal is not supplied to the horizontal counter control circuit 53h which detects when the absolute horizontal position count reaches a previously determined value which coincides with the beginning of the effective horizontal range included within the effective picture area. When this previously determined absolute horizontal position count is reached, the counter control circuit 53h resets the horizontal address counter 55h, thereby permitting the horizontal address counter to count the clock signal supplied to the clock signal input terminal 63.

The horizontal address counter 55h is incremented in synchronism with the shifting of bits into the shift register 50. The count of the horizontal address counter is used as an address in which parallel bits in the shift register 50 are written into and stored in the memory 13. Thus, as the horizontal address count changes, the memory address likewise changes to define new storage locations in which the graphic title image data are stored.

The vertical absolute position counter 52v, the vertical counter control circuit 53v and the vertical address counter 55v function in a substantially similar manner, except that the vertical absolute position counter 52v and the vertical address counter 55v count horizontal synchronizing signals, and the vertical absolute position counter 52v is reset in response to the vertical synchronizing signal. Nevertheless, when the absolute vertical position count reaches a previously determined value, the vertical counter control circuit 53v resets the vertical address counter 55v, thereby enabling the vertical address counter 55v to count horizontal synchronizing signals. Each count of the vertical address counter 55v serves as a new address for the memory 13; and it is appreciated that, in one embodiment, the memory 13 may be thought of as a matrix array with each storage location defined by a horizontal address and a vertical address. Thus, successive groups of serialized graphic title image bits are converted to parallel form and are stored at the address then defined by the counts of the horizontal address counter 55h and the vertical address counter 55v.

Figure 5 illustrates the manner in which the counter control circuits 53h and 53v convert the horizontal and vertical absolute position counts to horizontal and vertical address counts which define the effective horizontal and vertical ranges of the picture area. Thus, horizontal address counts H0 from, for example, 0 to h, and vertical address counts V0 from, for example, 0 to v represent the effective image plane of the video signal. Preferably, the graphic title image data are stored only in those locations in the memory 13 that are included within this effective image plane. As used herein, the horizontal image range includes horizontal counts 0 to h; and the vertical image range includes counts 0 to v.

A superimposition operation of the graphic title image data thus stored in the memory 13 now will be described. Let is be assumed that the read switch 32 is closed, thereby supplying a read enable signal to the memory 13. As was carried out during the write operation, the absolute position counters 52h and 52v are incremented from counts 0 to x and 0 to y, respectively, and the address counters 55h and 55v are incremented from counts 0 to h and 0 to v, respectively, under the control of the counter control circuits 53h and 53v, respectively. Thus, as was done during the write operation, the horizontal and vertical address counters 55h and 55v generate addresses within the horizontal and vertical image ranges, similar to the write addresses and are shown in Figure 5.

As the memory address defined by the horizontal and vertical address counts H0 and V0 change, the graphic title image data stored in the addressed locations are transferred to the data output port 81 and loaded in parallel into the shift register 50. The shift register 50 responds to clock pulses supplied thereto to shift the content thereof serially to the gate circuit 51. The successive reading of graphic title image data from the memory 13 to the shift register 50 and the shifting of the contents of the shift register 50 through the gate circuit 51 result in serial graphic title image data corresponding to the graphic information 102 shown in Figure 5. This figure represents the juxtaposition of the graphic image and the horizontal and vertical addresses generated by the address counters 55h and 55v.

The horizontal image range defining circuit 54h detects when the count of the horizontal address counter 55h is within the range 0 to h to supply an enabling signal to the gate circuit 51. Similarly, the vertical image range defining circuit 54v senses when the count of the vertical address counter 55v is within the range 0 to v to supply an enabling signal to the gate circuit 51. When the horizontal and vertical gate enabling signals coincide, the gate circuit 51 opens to pass the graphic title image data serially from the shift register 50.

Depending upon which of the switches 77, 78 and 79 is actuated, the passed graphic title image data are modulated with red, green or blue colour signals and supplied from the output terminal 71, 72 or 73 to the converting circuit 15 (Figure 2). As mentioned above, the R, G, B graphic title image signals are converted by the converting circuit 15 to luminance and colour difference signals that are supplied to the superimposing circuits 5, 6 and 7. It also is appreciated that the superimpose control signal generator 57 responds to the graphic title image data passed by the gate circuit 51 to supply a blanking signal BLK coincident with the graphic title image signals to the superimposing circuits 5, 6 and 7. When the blanking signal is received, the superimposing circuits 5, 6 and 7 replace that portion of the video signal then being received from the image processing circuit 4 (that is, the video signal picked up by the CCD 1) with the graphic title image video signals produced by the converting circuit 15. Thus, graphic title image information is superimposed onto the composite video signal then being produced by the video camera 30. Hence, a scene which is in the process of being imaged by the CCD 1 has superimposed thereon graphic title image signals such that the video picture derived therefrom, as may be recorded by the VTR 20, contains the superimposed graphic material.

Thus, the graphic title image signals superimposed onto the picked up video signals (referred to as the input video signal) may be scrolled in the horizontal and vertical direction. That is, the relative position of the graphic title image signals superposed onto the input video signal may be shifted such that when a video picture thereof is displayed, the graphic material derived from the graphic title image signals appears to shift, or scroll, horizontally and vertically. Preferably, this horizontal movement is carried out in the right-to-left direction and the vertical movement is carried out from bottom-to-top of the video picture. Horizontal scrolling is achieved by closing the switch 33h, and vertical scrolling is achieved by closing the switch 33v. The manner in which shown such scrolling is carried out now will be described.

It is assumed that the switch 32 is actuated to supply the memory 13 with the read enable signal. Let it be further assumed that the horizontal scroll switch 33h is actuated. Thus, the scroll control circuit 56 supplied a signal to the horizontal counter control circuit 53h to vary the absolute horizontal position count which is detected for resetting the horizontal address counter 55h. The scroll control signal also is supplied to the horizontal image range defining circuit 54h to enable it to vary the beginning of the horizontal gate enabling signal produced thereby, yet permit the horizontal image range defining circuit 54h to terminate that enabling signal when the count of the horizontal absolute position counter 52h reaches the count corresponding to the end of the horizontal image range (represented in Figure 5 as count x - 2).

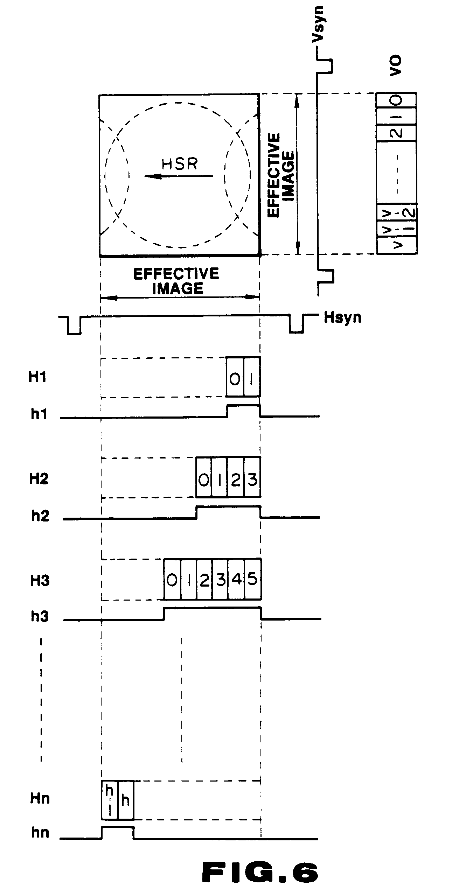

Now, with reference to Figure 6, if the horizontal scroll switch 33h remains closed, the scroll control signal supplied to the horizontal counter control circuit 53h by the scroll control circuit 56 causes the horizontal counter control circuit 53h to vary the absolute horizontal position address count that is detected and used to reset the horizontal address counter 55h by a predetermined number of addresses every m frames. For example, during a particular frame, let is be assumed that the counter control circuit 53h resets the horizontal address counter when the absolute horizontal position count is equal to (x - 4). At that time, the horizontal address count is reset, as represented by counts H1 in Figure 6, and the horizontal image range defining circuit 54h commences the horizontal gate enabling pulse, as represented by pulse h1 in Figure 6. Now, when the absolute horizontal position count reaches (x - 1), the horizontal image range defining circuit 54h terminates the horizontal gate enabling pulse h1, as shown. The graphic title image data stored at those memory locations addressed by horizontal address counts H1 and read therefrom, loaded into the shift register 50 and then gated out of the shift register 50 during the interval of the horizontal gate enabling pulse h1. The resultant graphic title image signals which are superimposed onto the input video signal produce an effective image of the type shown at the top of Figure 6.

Now, m frames later, as may be determined by the counting of vertical synchronizing signals by the horizontal counter control circuit 53h, the horizontal counter control circuit 53h functions to detect when the absolute horizontal position count is equal to, for example, (x - 6) to reset the horizontal address counter 55h. As a result, horizontal address counts H2 are generated, resulting in horizontal gate enabling pulse h2. As before, the graphic title image data stored at memory locations addressed by horizontal address counts H2 are read therefrom, loaded into the shift register 50 and gated out of the shift register 50 by the gate circuit 51 during the interval defined by horizontal gate enable pulse h2. It is appreciated that this shifting of the horizontal address counts H2 results in a right-to-left shift of the graphic title image information superimposed onto the input video signal and displayed as a video picture.

Next, m frames later, the horizontal counter control circuit 53h detects when the absolute horizontal position count is equal to (x - 8) to reset the horizontal address counter 55h. Now, the horizontal address counts appear as counts H3, resulting in the horizontal gate enable pulse shown at h3. This provides a further right-to-left shifting in the graphic title image data read from the memory 13 and superimposed by the gate circuit 51, the converting circuit 15 (FIgure 2) and superimposing circuits 5, 6 and 7 on the input video signal. The graphic material displayed from the superimposed graphic title image signals also appears to shift in the right-to-left direction.

The foregoing shifting in the absolute horizontal position count which is detected for resetting the horizontal address counter 55h continues by, for example, two address counts (as discussed in the foregoing examples) every m frames. It is appreciated that this shifting may be any desired number of addresses and may be repeated at every m frames or at every m fields, wherein m is an integer. Such shifting in the absolute horizontal position count that is used to reset the horizontal address counter 55h may be achieved by, for example, subtracting a desired count (which may vary every m frames or fields) from the absolute horizontal position count and then detecting when the difference count reaches the value which has been discussed above as the value representing the beginning of the horizontal image range. For example, if the absolute horizontal position count 2 (Figure 5) represents the beginning of the horizontal image range, then by subtracting a desired count therefrom, the horizontal address count is not reset until the absolute horizontal position count has been incremented by that amount which has been subtracted. As shown in Figure 6, when a large count value is subtracted, the horizontal address counter is reset close to the vicinity of the end of the horizontal image range. As this value is reduced, the resetting of the horizontal address counter shifts towards the beginning of the horizontal image range, as shown in Figure 6.

To continue the right-to-left shifting of horizontal address counts relative to the absolute horizontal position count, thereby shifting the graphic title image data relative to the input video signal, once a zero-value count is subtracted from the absolute horizontal position count, the horizontal address counter 55h thereafter may be present to a positive address count other than 0 when a predetermined count of the absolute horizontal position count is detected. Accordingly, when the absolute horizontal position count reaches a count of 2 (which, as shown in Figure 5, had been used previously to reset horizontal address counter 55h), the horizontal address counter 55h now may be preset to a desired count. As a result of this presetting of the horizontal address counter 55h, its count h is reached prior to the time that the absolute horizontal position count reaches the count of (x - 2). In Figure 5, a horizontal address count h had been used to terminate the horizontal gate enable signal produced by the horizontal image range defining circuit 54h. This same count h may be used to reset the horizontal gate enable signal; but now the resetting of that signal appears to shift in the right-to-left direction, as shown in Figure 6. It is recognized that horizontal address counts Hn are preset to the count (h - 1) when the absolute horizontal position count reaches the count of 2, at which time the horizontal gate enable signal hn is initiated. Then, when the horizontal address count increments to the count of h, the horizontal gate enable signal terminates at the next clock pulse, as shown at hn in Figure 6.

Therefore, it is recognized that the graphic title image signals, resulting in a graphic picture of the type shown at the top of Figure 6, shifts in the horizontal direction, as represented by arrow HSR, when the horizontal scroll switch 33h is closed. This shifting changes by a predetermined amount (shown in Figure 6 as equal to 2 horizontal address counts) every m fields or frames.

In the aforedescribed horizontal scrolling operation, it is assumed that the vertical address counter 55v generates vertical addresses from 0 to v through the effective vertical range of the video picture, discussed previously with respect to Figure 5. Thus, Figure 6 illustrates the vertical address counts VO which are equal to those used during a graphic title image data write operation and also used during a non-scrolling graphic title image data superposition operation. That is, Figure 6 has been discussed in the case where there is no vertical scrolling of the graphic title image signals.

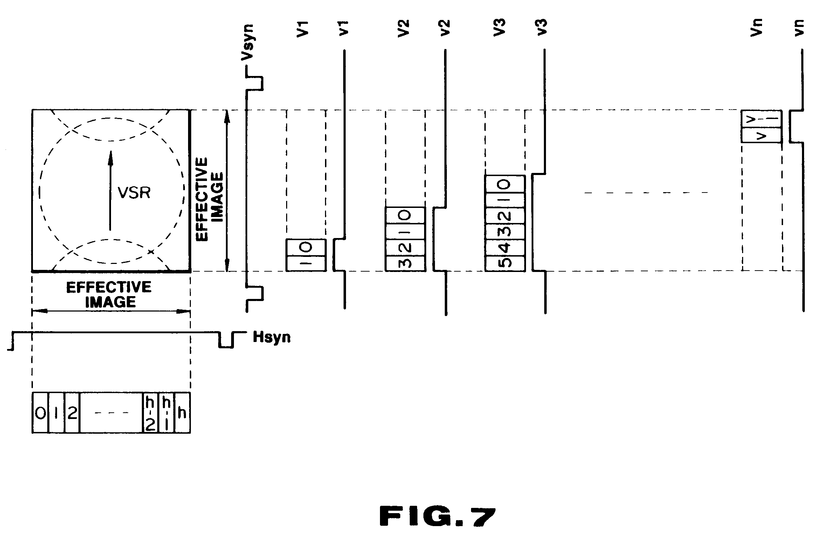

Let it now be assumed that the vertical scroll switch 33v is closed. As a result, the scroll control circuit 56 supplies a scroll control signal to the vertical counter control circuit 53v and also to the vertical image range defining circuit 54v. The vertical counter control circuit 53v functions in a manner analogous to that of horizontal counter control circuit 53h to detect the absolute vertical position count reached by the vertical absolute position counter 52v for the purpose of resetting the vertical address counter 55v. Figure 7 illustrates the manner in which the vertical address count is reset at different absolute vertical position counts, resulting in a changing of vertical address counts V1, V2, V3, ...Vn. When, for example, the vertical address count is reset, the vertical image range defining circuit 54v initiates the vertical gate enable signal, thereby changing the time at which this enable signal begins, as depicted at v1, v2, v3, ...vn in Figure 7. Preferably, the vertical gate enable signal terminates either when the absolute vertical position count reaches a predetermined count, such as the count (y - 1) shown in Figure 5, or when the vertical address count reaches the value v, as represented by vertical gate enable signal vn in Figure 7.

The operation of titler apparatus 12 as represented by Figure 7 results in a changing of vertical address counts V by a predetermined amount, such as two counts, every m fields or frames. Consequently, the address locations of the memory 13 which are read during each effective image interval appears to shift in the upward direction; and the graphic title image data read from the memory 13 is gated out of the shift register 50 during the interval determined by vertical gate enable signal v1...vn. As a result, the graphic title image data appears to shift, or scroll, upwardly in the vertical direction, as represented by arrow VSR in Figure 7.

It is apparent from Figure 7 that the aforedescribed vertical scrolling operation is carried out without changing the horizontal address counts. If the horizontal addresses are changed, as was described above with respect to Figure 6, the resultant scrolling of the graphic title image signals superimposed onto the input video signal will appear as both vertical and horizontal movement, that is diagonal movement, of the graphic image signals.

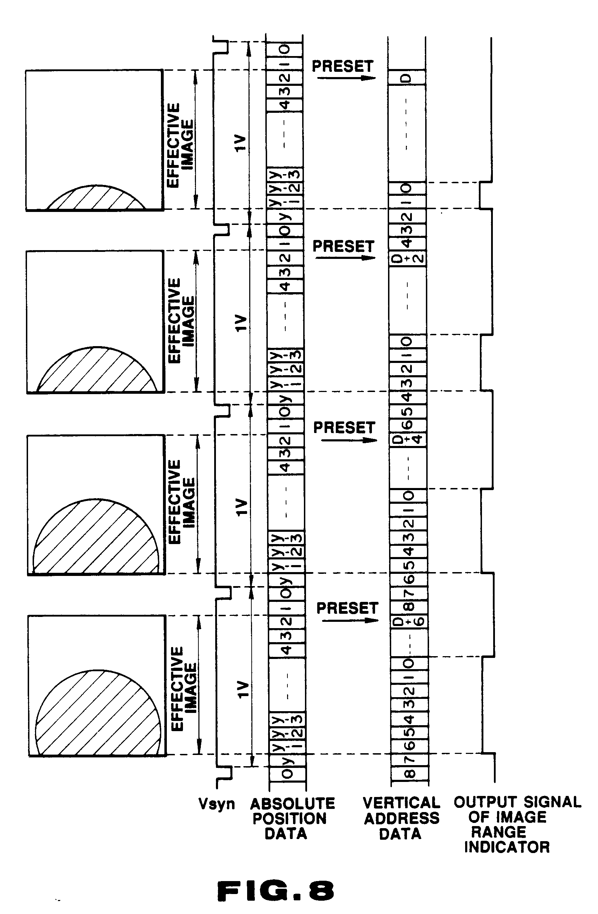

Two alternative techniques now will be described for controlling the horizontal and vertical address counters to effect a scrolling operation. Since both the address counters 55h and 55v may be controlled in substantially the same manner, for the purpose of simplification and convenience and in order to avoid duplicate explanation, the following description is directed to controlling the vertical address counter 55v. Turning to Figure 8, a diagrammatic representation is provided to illustrate that the vertical counter control circuit 53v detects when the absolute vertical position count reaches a previously determined value identifying the beginning, or top, of the vertical image plane to preset the vertical address counter 55v to a desired count. The vertical address counter 55v is then incremented from its preset count until a predetermined address (such as address 0) is reached. At that time, the vertical image range defining circuit 54v responds to this predetermined address to initiate the vertical gate enable signal. This gate enable signal is terminated when the absolute vertical position count supplied to the vertical image range defining circuit 54v reaches a desired count, such as count (y - 1).

As also shown in Figure 8, m frames (or fields) later, the vertical counter control circuit 53v presets the vertical address counter 55v to a different count at the beginning of the vertical image range, as represented by preset count D + 2. With this different preset count, the vertical address count reaches the predetermined address 0 sooner than had been reached when the count had been preset to the count D. Thus, the vertical address counts appear to be shifted in the upward direction and, additionally, the vertical gate enable signal likewise appears to be enlarged upwardly from the bottom of the vertical image range.

Figure 8 depicts this upward shifting in the vertical address counts as the vertical address counter 55v is preset to different counts (D, D + 2, D + 4, D + 6, etc.) every m frames (or fields). Thus, graphic title image date read from the memory 13 appears to be shifted in the upward direction; and the resultant video picture that is derived from this graphic title image data likewise appears to scroll upwardly across the picture area.

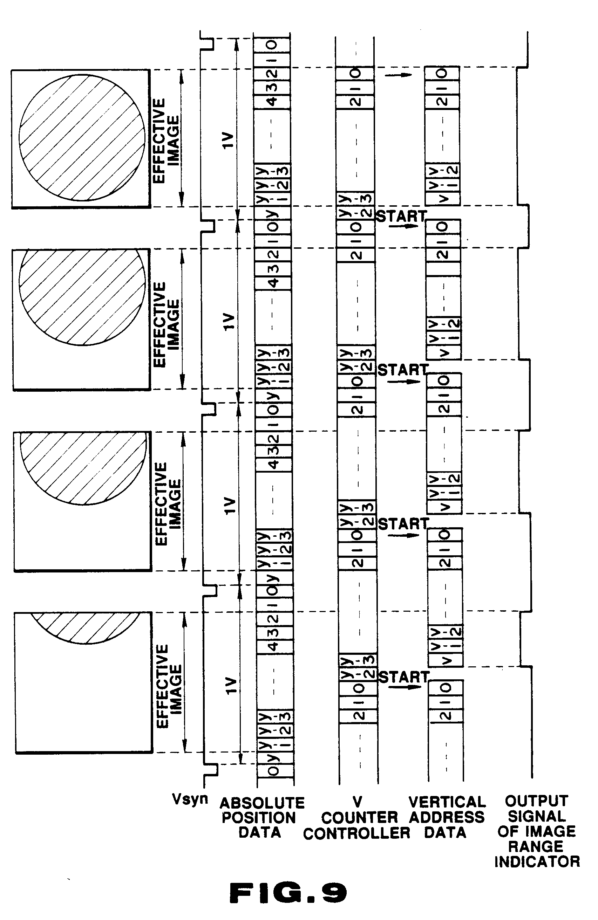

As an alternative address counter control operation, the counter control circuit 53v resets the vertical address counter 55v in response to different absolute vertical position counts, as shown in Figure 9. In this alternative, the vertical image range defining circuit 54v responds to a predetermined absolute vertical position count (such as count 2) to initiate the vertical gate enable signal, and then responds to the predetermined vertical address count (for example, count v) to terminate that signal. By changing the absolute vertical position count at which the vertical address counter 55v is reset, the vertical address count appears to shift in the upward direction, as represented by Figure 9. The vertical counter control circuit 53v may change the absolute vertical position count which is detected for resetting the vertical address counter every m frames (or fields). In Figure 9, for convenience, m = 1.

Figure 9 illustrates, as one example, the resetting of the vertical address counter 55v when the absolute vertical position count reaches a count of, for example, two. The vertical gate enable signal produced by the vertical image range defining circuit 54v is coextensive, at this time, with the effective vertical range. If, now the vertical address counter is reset when the vertical absolute position count reaches a count of zero, the graphic title image data stored at locations corresponding to vertical addresses 2 to v are read out and gated through the gate circuit 51.

It is seen that the vertical address counts continue to be shifted in what appears to be an upward direction, with a concomitant shifting in the vertical gate enable signal, as the vertical counter control circuit 53v regresses the absolute vertical position count which is detected for resetting the vertical address counter 55v.

From the foregoing, it is appreciated that the scroll rate, or speed at which the graphic title image information appears to move across the video picture area, is a function of the rate at which the horizontal and vertical address counts are changed and the amount of each change. For example, if the address counts are changed by one count every twenty frames, a relatively slow scrolling effect is achieved. This scrolling effect is accelerated if the address counts are changed by one count every frame, or by two counts every four frames, etc.

Preferably, the input video signal having the graphic title image signals superimposed thereon are supplied to the viewfinder 40 by the NTSC encoder 8 (Figure 2). A user thus may observe the superimposed graphic information and also be apprised of the particular colour used to modulate that information. A change in colour may be made by actuating the switch 34, as discussed above. In the event that the viewfinder 40 displays a monochrome video picture, a suitable colour indication may nevertheless be displayed.

Various changes may of course be made. For example, the graphic title image data need not be derived solely by imaging a placard 100, as represented in Figure 1. Rather, graphic video signals may be reproduced by a VTR (or the like) and supplied to the A/D converter 11 (Figure 2). Also, other techniques may be used to control the horizontal and vertical address counters 55h and 55v so as to vary the interval during which the gate circuit 51 is enabled. Likewise, the full contents of the memory 13 may be loaded into the shift register 50, but only a portion of the graphic title image data in the shift register 50 may be gated out, depending upon the interval of the horizontal and vertical gate enable signals. The result still would achieve a horizontal and vertical scrolling effect of the type discussed above in conjunction with Figures 6 to 9.

## Claims

1. Apparatus for superimposing graphic image signals onto a video signal, the apparatus comprising:
addressable storage means (13) for storing graphic image data representing respective elements of respective horizontal lines of a graphic image (101);
a source (2, 64h, 64v) of horizontal and vertical synchronizing signals (HSYNC, VSYNC) synchronized with such signals of said video signal;
a source (63) of clock pulses (CLK) of a frequency which divides a horizontal line interval into multiple discrete zones;
horizontal and vertical address counting means (55h, 55v) for generating timed address signals to read out said image data from said addressable storage means (13);
means for supplying said clock pulses (CLK) to said horizontal address counting means (55h) for counting thereby, whereby said count of said horizontal address counting means represents a horizontal address (H.ADD DATA);
means for supplying said horizontal synchronizing signals (HSYNC) to said vertical address counting means (55h) for counting thereby, whereby said count of said vertical address counting means represents a vertical address (V.ADD DATA);
horizontal and vertical absolute position counters (52h, 52v) for counting said clock pulses (CLK) and said horizontal synchronizing signals (HSYNC) respectively;
means for resetting said horizontal and vertical absolute position counters (52h, 52v) in response to said horizontal and vertical synchronizing signals (HSYNC, VSYNC) respectively;
horizontal and vertical counter control means (53h, 53v) coupled to said horizontal and vertical absolute position counters (52h, 52v) for setting said horizontal and vertical address counting means (55h, 55v) to preset counts when said horizontal and vertical absolute position counters reach predetermined counts;
horizontal and vertical image range defining means (54h, 54v) coupled to said horizontal and vertical address counting means (55h, 55v) and said horizontal and vertical absolute position counters (52h, 52v) for enabling reading of said graphic image data from said addressable storage means (13) when counts of said horizontal and vertical absolute position counters are within an effective horizontal and vertical image range of addresses (2 to x-2, 2 to y-1) corresponding to the effective picture area (height and width) of a video picture derived from said video signal and counts of said horizontal and vertical address counting means (55h, 55v) are within a horizontal and vertical range corresponding to said graphic image data;
shift means (56) for changing one or more of said preset counts by a predetermined number for every m repetition periods to scroll said graphic image (13) across said picture area, wherein m is an integer and said repetition periods are either vertical field intervals or vertical frame intervals of said video signal;
image signal generating means (15) for generating graphic image signals from said graphic image data read out from said storage means (13);
superimposing means (5, 6, 7, 57) for receiving said video signal and said graphic image signals to superimpose said graphic image signals onto said video signal; and
output means (51) enabled by said horizontal and vertical counting control means (54h, 54v) to supply said image signal generating means (15) read out graphic image data from said addressable storage means (13), whereby a video picture derived from said video signal output by said superimposing means (5, 6, 7, 57) represents a graphic image that scrolls said effective picture area.

2. Apparatus according to claim 1 further comprising data generating means (1) for generating graphic title image data; and write means for writing the generated graphic title image data into said addressable storage means (13).

3. Apparatus according to claim 2 wherein said data generating means (1) includes image pick-up means (1) for picking up an image of graphic data and producing therefrom said graphic title image data.

4. Apparatus according to claim 3 wherein said write means includes said horizontal and vertical address counting means (55h, 55v) for generating successive write address signals to write said graphic title image data into locations of said addressable storage means (13) addressed by said write address signals.

5. Apparatus according to any one of the preceding claims wherein said output means (51) comprises gate means (51); horizontal gate enabling means for supplying a horizontal gate enabling signal to said gate means (51) when the address of said horizontal address counting means (55h) is within said effective range; vertical gate enabling means for supplying a vertical gate enabling signal to said gate means when the address of said vertical address counting means (55v) is within said effective range; register means (50) coupled to said addressable storage means (13) to receive the graphic image data read out from said addressable storage means (13) and to supply said graphic image data to said gate means (51) to pass therethrough when said gate means (51) is enabled by said horizontal and vertical gate enabling signals; and colour selecting means (71 to 79) operable to select colour modulating signals for modulating the graphic image data passed by said gate means (51).

6. Apparatus according to claim 5 wherein said colour selecting means (71 to 79) includes switch means (77 to 79), and primary colour signal generating means (74 to 76); said switch means (77 to 79) being selectively operable to supply the graphic image data passed by said gate means (51) to at least a selected one of said colour signal generating means (74 to 76) for producing a corresponding colour graphic image signal.

7. Apparatus according to claim 5 wherein said image signal generating means (15) comprises converting means (15) coupled to said colour selecting means (71 to 79) for converting the colour modulated graphic image data to luminance and colour difference video signals.

8. Apparatus according to claim 7 wherein said superimposing means (5, 6, 7, 57) comprises a superimpose control signal generator (57) for generating a superimpose control signal when graphic image data are passed by said gate means (51); and a plurality of superimposing means (5, 6, 7) each supplied with a respective luminance or colour difference component of said input video signal and with a respective luminance or colour difference video signal produced by said converting means (15) and responsive to said superimpose control signal to substitute the luminance and colour difference video signals from said converting means (15) for the luminance and colour difference components of said video signal.

9. Apparatus according to claim 8 wherein said video signal is produced by a video camera (30).

10. Apparatus according to claim 9 wherein said video camera (30) includes CCD image pick-up means (1) for generating said video signal.

11. Apparatus according to claim 8 wherein said shift means (56) includes scroll means (56) selectively operative to supply horizontal scroll signals to said horizontal counter control means (53h) for changing said preset count of said horizontal address counting means (55h) and thereby scroll the graphic image horizontally in the video picture.

12. Apparatus according to claim 11 wherein said horizontal address counting means (55h) is resettable to a predetermined address to establish the beginning of said effective image range in the horizontal direction; and wherein said horizontal counter control means (53h) is responsive to a horizontal scroll signal to preset said horizontal address counting means (55h) to a changed address, whereby said predetermined address is produced at a location shifted from the beginning and within said effective image range.

13. Apparatus according to claim 8 wherein said shift means (56) includes scroll means (56) selectively operative to supply vertical scroll signals to said vertical counter control means (53v) for changing said preset count of said vertical address counting means (55v) and thereby scroll the graphic title image vertically in the video picture.

14. Apparatus according to claim 13 wherein said vertical address counting means (55v) is resettable to a predetermined address to establish the beginning of said effective image range in the vertical direction; and wherein said vertical counter control means (53v) is responsive to a vertical scroll signal to preset said vertical address counting means (55v) to a changed address, whereby said predetermined address is produced at a location shifted from the beginning and within said effective image range.

15. Apparatus according to any one of the preceding claims wherein m is 1.

16. Apparatus according to any one of the preceding claims further comprising a main power source (+V), and wherein said addressable storage means (13) comprises a static RAM (13) and a power supply (14) coupled thereto for preserving the contents stored therein when main power from said power source (+V) is interrupted.

## Patentansprüche

1. Vorrichtung zur Überlagerung von graphischen Bildsignalen über ein Videosignal, die folgende Merkmale aufweist:
eine adressierbare Speichereinrichtung (13) zur Speicherung von graphischen Bilddaten, die jeweils Elemente von entsprechenden horizontalen Zeilen eines graphischen Bildes (101) darstellen,
eine Quelle (2, 64h, 64v) für horizontale und vertikale Synchronisiersignale (HSYNC, VSYNC), die mit den entsprechenden Signalen des Videosignals synchronisiert sind,
eine Quelle (63) für Taktimpulse (CLK) mit einer Frequenz, die ein horizontales Zeilenintervall in mehrere diskrete Zonen unterteilt,
einer horizontalen und einer vertikalen Adressenzähleinrichtung (55h, 55v) zur Erzeugung von zeitlich abgestimmten Adressensignalen zum Auslesen der Bilddaten aus der adressierbaren Speichereinrichtung (13),
eine Einrichtung zur Zuführung der Taktimpulse (CLK) zu der horizontalen Adressenzähleinrichtung (55h) zum Abzählen durch letztere, wobei der Zählerstand der horizontalen Adressenzähleinrichtung eine horizontale Adresse (H.ADD DATA) repräsentiert,
eine Einrichtung zur Zuführung der horizontalen Synchronisiersignale (HSYNC) zu der vertikalen Adressenzähleinrichtung (55v) zum Abzählen durch letztere, wobei der Zählerstand der vertikalen Adressenzähleinrichtung eine vertikalen Adresse (V.ADD DATA) repräsentiert,
Zähler (52h, 52v) für die horizontale und vertikale Absolutposition zum Abzählen der Taktimpulse (CLK) bzw. der horizontalen Synchronisiersignale (HSYNC),
eine Einrichtung zum Rückstellen der Zähler (52h, 52v) für die horizontale und vertikale Absolutposition in Abhängigkeit von den horizontalen bzw. vertikalen Synchronisiersignalen (HSYNC, VSYNC),
mit den Zählern (52h. 52v) für die horizontale und die vertikale Absolutposition verbundene horizontale und vertikale Steuereinrichtungen (53h, 53v) für die Einstellung der horizontalen und vertikalen Adressenzähleinrichtungen (55h, 55v) auf voreingestellte Zählerstände, wenn die Zähler für die horizontale und die vertikale Absolutposition vorbestimmte Zählerstände erreichen,
mit den horizontalen und vertikalen Adressenzähleinrichtungen (55h, 55v) und den Zählern (52h, 52v) für die horizontale und die vertikale Absolutposition verbundene Einrichtungen (54h, 54v) zur Bestimmung des horizontalen und vertikalen Bildbereichs für die Aktivierung des Auslesens der graphischen Bilddaten aus der adressierbaren Speichereinrichtung (13), wenn die Zählerstände der Zähler für die horizontale und die vertikale Absolutposition innerhalb eines effektiven horizontalen und vertikalen Bildbereichs von Adressen (2 bis x-2, 2 bis y-1) liegen, die den effektiven Bildbereich (Höhe und Breite) eines aus dem genannten Videosignal abgeleiteten Videobildes entsprechen und die Zählerstände der horizontalen und vertikalen Adressenzähleinrichtung (55h, 55v) in einem den graphischen Bilddaten entsprechenden horizontalen und vertikalen Bereich liegen,
eine Verschiebungseinrichtung (56) zur Änderung eines oder mehrerer der voreingestellten Zählerstände um eine vorbestimmte Zahl bei jeweils m Wiederholungsperioden, um einen Bildlauf des graphischen Bildes über den Bildbereich herbeizuführen, wobei m eine ganze Zahl ist und die Wiederholungsperioden entweder vertikale Halbbildintervalle oder vertikale Vollbildintervalle des Videosignals sind,
eine Bildsignalerzeugungseinrichtung (15) zur Erzeugung graphischer Bildsignale aus den aus der Speichereinrichtung (13) ausgelesenen graphischen Bilddaten,
eine mit dem Videosignal und den graphischen Bildsignalen gespeiste Überlagerungseinrichtung (5, 6, 7, 57) zur Überlagerung der graphischen Bildsignale über das Videosignal,
sowie eine von der horizontalen und vertikalen Zählsteuereinrichtung (54h, 54v) aktivierte Ausgabeeinrichtung (51) zur Lieferung von aus der adressierbaren Speichereinrichtung (13) ausgelesenen graphischen Bilddaten an die Bildsignalerzeugungseinrichtung (15), wodurch ein aus dem von der Überlagerungseinrichtung (5, 6, 7, 57) ausgegebenen Videosignal abgeleitetes Videobild ein graphisches Bild repräsentiert, das einen Bildlauf über die effektive Bildfläche ausführt.

2. Vorrichtung nach Anspruch 1, die ferner eine Datenerzeugungseinrichtung (1) zur Erzeugung graphischer Titelbilddaten sowie eine Schreibeinrichtung zum Einschreiben der so erzeugten graphischen Titelbilddaten in die adressierbare Speichereinrichtung (13) aufweist.

3. Vorrichtung nach Anspruch 2, bei der die Datenerzeugungseinrichtung (1) einer Bildaufnahmeeinrichtung (1) zur Aufnahme eines Bildes graphischer Daten und zur Erzeugung der graphischen Titelbilddaten aus letzteren aufweist.

4. Vorrichtung nach Anspruch 3, bei der die Schreibeinrichtung die horizontale und vertikale Adressenzähleinrichtung (55h, 55v) zur Erzeugung aufeinanderfolgender Schreibadressensignale für das Einschreiben der graphischen Titelbilddaten an durch die Schreibadressensignale adressierten Stellen der adressierbaren Speichereinrichtung (13) enthält.

5. Vorrichtung nach einem der vorgehenden Ansprüche, bei der die Ausgabeeinrichtung (51) aufweist:
eine Torschalteinrichtung (51),
eine horizontale Torschaltungsaktivierungseinrichtung zum Zuführen eines horizontalen Torschaltungsaktivierungssignals zu der Torschalteinrichtung (51), wenn die Adresse der horizontalen Adressenzähleinrichtung (55h) innerhalb des genannten effektiven Bereichs liegt,
eine vertikale Torschaltungsaktivierungseinrichtung zum Zuführen eines vertikalen Torschaltungsaktivierungssignals zu der Torschalteinrichtung (51), wenn die Adresse der vertikalen Adressenzähleinrichtung (55v) innerhalb des genannten effektiven Bereichs liegt,
eine mit der adressierbaren Speichereinrichtung (13) verbundene Registereinrichtung (50) zur Aufnahme der aus der adressierbaren Speichereinrichtung (13) ausgelesenen graphischen Bilddaten und zur Zuführung dieser graphischen Bilddaten zu der Torschalteinrichtung (51) zur Durchschaltung durch diese, wenn die Torschalteinrichtung (51) durch das horizontale und vertikale Torschaltungsaktivierungssignal aktiviert ist,
sowie eine Farbauswahleinrichtung (71 bis 79) zur Auswahl von Farbmodulationssignalen zum Modulieren der von der Torschalteinrichtung (51) durchgeschalteten graphischen Bilddaten.

6. Vorrichtung nach Anspruch 5, bei der die Farbauswahleinrichtung (71 bis 79) Schaltmittel (77 bis 79) und Einrichtungen (74 bis 76) zur Erzeugung von Primärfarben aufweist, wobei diese Schaltmittel (77 bis 79) selektiv so betätigbar sind, daß die von der Torschalteinrichtung (51) durchgeschalteten graphischen Bilddaten wenigstens einem ausgewählten Exemplar der Einrichtungen (74 bis 76) zur Erzeugung von Primärfarben zugeführt werden, um ein entsprechendes graphisches Farbbildsignal zu erzeugen.

7. Vorrichtung nach Anspruch 5, bei der die Bildsignalerzeugungseinrichtung (15) ein mit der Farbauswahleinrichtung (71 bis 79) verbundene Umwandlungseinrichtung (15) zur Umwandlung der farbmodulierten graphischen Bilddaten in Luminanz- und Farbdifferenz-Videosignale aufweist.

8. Vorrichtung nach Anspruch 7, bei der die Überlagerungseinrichtung (5, 6, 7, 57) aufweist:
einen Überlagerungssteuersignalgenerator (57) zur Erzeugung eines Überlagerungssteuersignals, wenn graphische Bilddaten von der Torschalteinrichtung (51) durchgeschaltet werden,
sowie eine Mehrzahl von Überlagerungseinrichtungen (5, 6, 7), denen jeweils eine entsprechende Luminanz- und Farbdifferenzkomponente des Eingangsvideosignals sowie ein entsprechendes, von der Umwandlungseinrichtung (15) erzeugtes Luminanz- und Farbdifferenz-Videosignal zugeführt werden und die auf das Überlagerungssteuersignal in der Weise reagieren, daß sie die Luminanz- und Farbdifferenzkomponenten des Videosignals durch die Luminanz- und Farbdifferenz-Videosignale aus der Umwandlungseinrichtung (15) substituieren.

9. Vorrichtung nach Anspruch 8, bei der das Videosignal von einer Videokamera (30) erzeugt wird.

10. Vorrichtung nach Anspruch 9, bei der die Videokamera (30) eine CCD-Bildaufnahmeeinrichtung (1) zur Erzeugung des Videosignals enthält.

11. Vorrichtung nach Anspruch 8, bei der die Verschiebungseinrichtung (56) eine Bildlaufeinrichtung (56) umfaßt, die der horizontalen Zählsteuereinrichtung (53h) selektiv horizontale Bildlaufsignale zuführt, um den voreingestellten Zählwert der horizontalen Adressenzähleinrichtung (55h) zu ändern und dadurch einen horizontalen Bildlauf der graphischen Bilddaten in dem Videobild herbeizuführen.

12. Vorrichtung nach Anspruch 11, bei der die horizontale Adressenzähleinrichtung (55h) auf eine vorbestimmte Adresse zurückstellbar ist, um den Anfang des effektiven Bildbereichs in horizontaler Richtung festzulegen, und bei der die horizontale Zählsteuereinrichtung (53h) auf ein horizontales Bildlaufsignal anspricht, um die horizontale Adressenzähleinrichtung (55h) auf eine geänderte Adresse voreinzustellen, wodurch die vorbestimmte Adresse an einer gegenüber dem Anfang verschobenen Stelle innerhalb des effektiven Bildbereichs erzeugt wird.

13. Vorrichtung nach Anspruch 8, bei der die Verschiebungseinrichtung (56) eine Bildlaufeinrichtung (56) umfaßt, die der vertikalen Zählsteuereinrichtung (53v) selektiv vertikale Bildlaufsignale zuführt, um den voreingestellten Zählwert der vertikalen Adressenzähleinrichtung (55v) zu ändern und dadurch einen vertikalen Bildlauf der graphischen Bilddaten in dem Videobild herbeizuführen.

14. Vorrichtung nach Anspruch 13, bei der die vertikale Adressenzähleinrichtung (55v) auf eine vorbestimmte Adresse zurückstellbar ist, um den Anfang des effektiven Bildbereichs in vertikaler Richtung festzulegen, und bei der die vertikale Zählsteuereinrichtung (53v) auf ein vertikales Bildlaufsignal anspricht, um die vertikale Adressenzähleinrichtung (55v) auf eine geänderte Adresse voreinzustellen, wodurch die vorbestimmte Adresse an einer gegenüber dem Anfang verschobenen Stelle innerhalb des effektiven Bildbereichs erzeugt wird.

15. Vorrichtung nach einem der vorhergehenden Ansprüche. bei der m gleich 1 ist.

16. Vorrichtung nach einem der vorhergehenden Ansprüche mit einer Hauptstromversorgungsquelle (+V), wobei die adressierbare Speichereinrichtung (13) ein statisches RAM (13) und eine mit diesem verbundene Stromversorgung (14) aufweist, um den darin gespeicherten Inhalt zu erhalten, wenn die Hauptstromversorgung aus der Hauptstromversorgungsquelle (+V) unterbrochen ist.

## Revendications

1. Appareil permettant de superposer des signaux d'image graphique sur un signal vidéo, l'appareil comprenant :
un moyen de mémoire adressable (13) pour stocker des données d'image graphique représentant des éléments respectifs de lignes horizontales respectives d'une image graphique (101) ;
une source (2, 64h, 64v) de signaux de synchronisation horizontale et verticale (HSYNC, VSYNC) synchronisés avec les signaux dudit signal vidéo ;
une source (63) d'impulsions d'horloge (CLK) d'une fréquence qui divise un intervalle de ligne horizontale en de multiples zones discrètes ;
des moyens de comptage d'adresses horizontale et verticale (55h, 55v) pour générer des signaux d'adresse cadencés pour lire lesdites données d'image dans ledit moyen de mémoire adressable (13) ;
un moyen pour appliquer lesdites impulsions d'horloge (CLK) audit moyen de comptage d'adresse horizontale (55h) pour réaliser ainsi un comptage et ainsi, ladite valeur de comptage dudit moyen de comptage d'adresse horizontale représente une adresse horizontale (H.ADD DATA) ;
un moyen pour appliquer lesdits signaux de synchronisation horizontale (HSYNC) audit moyen de comptage d'adresse verticale (55h) pour ainsi réaliser un comptage et ainsi, ladite valeur de comptage dudit moyen de comptage d'adresse verticale représente une adresse verticale (V.ADD DATA) ;
des compteurs de positions absolues horizontale et verticale (52h, 52v) pour respectivement compter lesdites impulsions d'horloge (CLK) et lesdits signaux de synchronisation horizontale (HSYNC) ;
un moyen pour remettre à l'état initial lesdits compteurs de positions absolues horizontale et verticale (52h, 52v) en réponse respectivement auxdits signaux de synchronisation horizontale et verticale (HSYNC, VSYNC) ;
des moyens de commande de compteurs horizontal et vertical (53h, 53v) couplés auxdits compteurs de positions absolues horizontale et verticale (52h, 52v) pour établir lesdits moyens de comptage d'adresses horizontale et verticale (55h, 55v) pour pré-établir des valeurs de comptage lorsque lesdits compteurs de positions absolues horizontale et verticale atteignent des valeurs de comptage prédéterminées ;
des moyens de définition de plages d'image horizontale et verticale (54h, 54v) couplés auxdits moyens de comptage d'adresses horizontale et verticale (55h, 55v) et auxdits compteurs de positions absolues horizontale et verticale (52h, 52v) pour permettre la lecture desdites données d'image graphique dans ledit moyen de mémoire adressable (13) lorsque les valeurs de comptage desdits compteurs de positions absolues horizontale et verticale sont dans une plage d'image horizontale et verticale efficace d'adresses (2 à x-2, 2 à y-1) correspondant à la zone d'image efficace (hauteur et largeur) d'une image vidéo dérivée à partir dudit signal vidéo et lorsque des valeurs de comptage desdits moyens de comptage d'adresses horizontale et verticale (55h, 55v) sont dans une plage horizontale et verticale correspondant auxdites données d'image graphique ;
un moyen de décalage (56) pour modifier une ou plusieurs desdites valeurs de comptage pré-établies d'un nombre prédéterminé pour chaque m périodes de répétition afin de défiler ladite image graphique (13) sur ladite zone d'image, m étant un entier et lesdites périodes de répétition étant soit des intervalles de trames verticaux soit des intervalles d'images verticaux dudit signal vidéo;
un moyen de génération de signal d'image (15) pour générer des signaux d'image graphique à partir desdites données d'image graphique lues dans ledit moyen de mémoire (13) ;
un moyen de superposition (5, 6, 7, 57) pour recevoir ledit signal vidéo et lesdits signaux d'image graphique afin de superposer lesdits signaux d'image graphique sur ledit signal vidéo ; et
un moyen de sortie (51) validé par lesdits moyens de commande de comptages horizontal et vertical (54h, 54v) afin d'appliquer audit moyen de génération de signal d'image (15) des données d'image graphique lues dans ledit moyen de mémoire adressable (13) et ainsi, une image vidéo dérivée à partir dudit signal vidéo émis en sortie par ledit moyen de superposition (5, 6, 7, 57) représente une image graphique qui défile dans ladite zone d'image efficace.

2. Appareil selon la revendication 1, comprenant en outre un moyen de génération de données (1) pour générer des données d'image de titre graphique ; et un moyen d'écriture pour écrire les données d'image de titre graphique générées dans ledit moyen de mémoire adressable (13).

3. Appareil selon la revendication 2, dans lequel ledit moyen de génération de données (1) inclut un moyen de saisie d'image (1) pour saisir une image de données graphique et pour produire à partir de celle-ci lesdites données d'image de titre graphique.

4. Appareil selon la revendication 3, dans lequel ledit moyen d'écriture inclut lesdits moyens de comptage d'adresses horizontale et verticale (55h, 55v) pour générer des signaux d'adresse d'écriture successifs afin d'écrire lesdites données d'image de titre graphique en des emplacements dudit moyen de mémoire adressable (13) adressés par lesdits signaux d'adresse d'écriture.

5. Appareil selon l'une quelconque des revendications précédentes, dans lequel ledit moyen de sortie (51) comprend un moyen de porte (51) ; un moyen de validation de porte horizontale pour appliquer un signal de validation de porte horizontale audit moyen de porte (51) lorsque l'adresse dudit moyen de comptage d'adresse horizontale (55h) est dans ladite plage efficace ; un moyen de validation de porte verticale pour appliquer un signal de validation de porte verticale audit moyen de porte lorsque l'adresse dudit moyen de comptage d'adresse verticale (55v) est dans ladite plage efficace ; un moyen de registre (50) couplé audit moyen de mémoire adressable (13) pour recevoir les données d'image graphique lues dans ledit moyen de mémoire adressable (13) et pour appliquer lesdites données d'image graphique audit moyen de porte (51) afin qu'elles puissent passer au travers lorsque ledit moyen de porte (51) est validé par lesdits signaux de validation de portes horizontale et verticale ; et des moyens de sélection de couleur (71 à 79) pouvant être activés pour sélectionner des signaux de modulation de couleur pour moduler les données d'image graphique qui ont passé par ledit moyen de porte (51).

6. Appareil selon la revendication 5, dans lequel lesdits moyens de sélection de couleur (71 à 79) incluent des moyens de commutateur (77 à 79) et des moyens de génération de signal de couleur primaire (74 à 76) ; lesdits moyens de commutateur (77 à 79) pouvant être activés sélectivement pour appliquer les données d'image graphique qui ont passé ledit moyen de porte (51) à au moins l'un sélectionné desdits moyens de génération de signal de couleur (74 à 76) pour produire un signal d'image graphique couleur correspondant.

7. Appareil selon la revendication 5, dans lequel ledit moyen de génération de signal d'image (15) comprend un moyen de conversion (15) couplé auxdits moyens de sélection de couleur (71 à 79) pour convertir les données d'image graphique modulées couleur en signaux vidéo de différence de luminance et de couleur.

8. Appareil selon la revendication 7, dans lequel ledit moyen de superposition (5, 6, 7, 57) comprend un générateur de signal de commande de superposition (57) pour générer un signal de commande de superposition lorsque des données d'image graphique sont passées par ledit moyen de porte (51) ; et une pluralité de moyens de superposition (5, 6, 7) dont chacun se voit appliquer une composante de différence de luminance ou de couleur respective dudit signal vidéo d'entrée et un signal vidéo de différence de luminance ou de couleur respectif produit par ledit moyen de conversion (15) et est sensible audit signal de commande de superposition pour remplacer les signaux vidéo de différence de luminance et de couleur provenant dudit moyen de conversion (15) par les composantes de différence de luminance et de couleur dudit signal vidéo.

9. Appareil selon la revendication 8, dans lequel ledit signal vidéo est produit par une caméra vidéo (30).

10. Appareil selon la revendication 9, dans lequel ladite caméra vidéo (30) inclut un moyen de saisie d'image CCD (1) pour générer ledit signal vidéo.

11. Appareil selon la revendication 8, dans lequel ledit moyen de décalage (56) inclut un moyen de défilement (56) qui fonctionne sélectivement pour appliquer des signaux de défilement horizontaux audit moyen de commande de compteur horizontal (53h) pour modifier ladite valeur de comptage préétablie dudit moyen de comptage d'adresse horizontale (55h) et pour ainsi défiler l'image graphique horizontalement dans l'image vidéo.

12. Appareil selon la revendication 11, dans lequel ledit moyen de comptage d'adresse horizontale (55h) peut être remis à l'état initial à une adresse prédéterminée pour établir le début de ladite plage d'image efficace suivant la direction horizontale ; et dans lequel ledit moyen de commande de compteur horizontal (53h) est sensible à un signal de défilement horizontal pour pré-établir ledit moyen de comptage d'adresse horizontale (55h) à une adresse modifiée et ainsi, ladite adresse prédéterminée est produite à un emplacement décalé par rapport au début et dans ladite plage d'image efficace.

13. Appareil selon la revendication 8, dans lequel ledit moyen de décalage (56) inclut un moyen de défilement (56) qui peut être activé sélectivement pour appliquer des signaux de défilement verticaux audit moyen de commande de compteur vertical (53v) pour modifier ladite valeur de comptage préétabli dudit moyen de comptage d'adresse verticale (55v) et pour ainsi défiler l'image de titre graphique verticalement dans l'image vidéo.

14. Appareil selon la revendication 13, dans lequel ledit moyen de comptage d'adresse verticale (55v) peut être remis à l'état initial à une adresse prédéterminée pour établir le début de ladite plage d'image efficace suivant la direction verticale ; et dans lequel ledit moyen de commande de compteur vertical (53v) est sensible à un signal de défilement vertical pour préétablir ledit moyen de comptage d'adresse verticale (55v) à une adresse modifiée et ainsi, ladite adresse prédéterminée est produite à un emplacement décalé par rapport au début et dans ladite plage d'image efficace.

15. Appareil selon l'une quelconque des revendications précédentes, dans lequel m vaut 1.

16. Appareil selon l'une quelconque des revendications précédentes, comprenant en outre une source d'alimentation principale (+V) et dans lequel ledit moyen de mémoire adressable (13) comprend une mémoire vive (RAM) statique (13) et une alimentation (14) qui lui est couplée pour préserver les contenus stockés en son sein lorsqu'une alimentation principale provenant de ladite source d'alimentation (+V) est interrompue.
